# EUROPEAN PATENT SPECIFICATION

(11) **EP 2 838 124 B1**
(45) Date of publication and mention of the grant of the patent: **22.03.2017**
(21) Application number: 13775048.5
(22) Date of filing: 04.02.2013
(51) Int. Cl.: H01L 31/18, H01L 31/042, B29D 7/01, B29C 31/02, B29C 31/06, B29C 41/36, H01L 31/048

(54) **APPARATUS FOR MANUFACTURING EVA SHEET FOR SOLAR CELL SEALANT**
VORRICHTUNG ZUR HERSTELLUNG EINER EVA-FOLIE FÜR SOLARZELLENDICHTUNGSMITTEL
APPAREIL DE FABRICATION DE FEUILLE D'ÉTHYLÈNE ACÉTATE DE VINYLE POUR MATÉRIAU D'ENCAPSULATION DE CELLULE SOLAIRE

(30) Priority: 09.04.2012 KR 20120036795
(43) Date of publication of application: 18.02.2015
(73) Proprietor: LG Hausys, Ltd., Seoul 150-721 (KR)
(72) Inventor: KIM, Chang Il, Cheongju-si Chungcheongbuk-do 360-776 (KR); PARK, Chang Hwan, Cheongju-si Chungcheongbuk-do 361-758 (KR); PARK, Sung Bae, Seoul 139-220 (KR)
(74) Representative: Zacco Sweden AB
(86) International application number: PCT/KR2013/000865
(87) International publication number: WO 2013/154262

(56) References cited:
- EP-A1- 0 721 829
- WO-A1-00/10802
- JP-A- H03 606
- JP-A- H10 217 336
- JP-A- 2009 262 430
- JP-A- 2011 023 415
- JP-A- 2011 023 415
- JP-B2- 2 786 885
- KR-A- 20110 022 680
- US-A- 3 400 186
- Anonymous: "Meyer - Scatter machines for powder, granulate, pellets, flakes and fibers", , 17 March 2006 (2006-03-17), XP055192385, Retrieved from the Internet: URL:http://web.archive.org/web/20060317212 632/http://www.meyer-machines.com/engl/Pro ducts/Scattering/scattering.html [retrieved on 2015-05-29]

## Description

### [Technical Field]

The present invention relates to an apparatus for manufacturing an EVA sheet for solar cell sealants, and more particularly, to an apparatus for manufacturing an EVA sheet for solar cell sealants, which manufactures an EVA sheet by uniformly arranging a thermal adhesive resin, followed by fusion-bonding.

### [Background Art]

Recently, instead of power generation relying on typical fossil fuels, solar cells directly converting sunlight, which is a clean energy source, into electric energy are being spotlighted. In particular, when solar cells are used outdoors, for example, on roofs of buildings, the solar cells are generally used in the form of a solar cell module.

Here, although most EVA sheets for solar cells are fabricated by extrusion or calendering, it is difficult to adjust the thickness of the sheet and thermal history remains in the EVA sheet, thereby causing thermal shrinkage in a machine direction (MD) during modularization of a solar cell. Moreover, since it is difficult to remove bubbles due to a dense structure of the sheet, there is a problem of long process time.

To solve such problems, Japanese Patent Publication No. 2002-363507 provides a thermal adhesive sheet exhibiting low thermal shrinkage, and discloses a method of preparing the same, in which thermal adhesive resin powder is sprayed onto a release paper through a spray machine, heated for partial or overall fusion-bonding of the powder, followed by cooling, and then the release paper is peeled off.

JP2011023415 discloses the use of a powder scattering device to spread EVA powder onto a peelable substrate in order to make a sheet for solar cells. WO00/10802 discloses a brush at the powder roll to remove excess powder. US3400186 discloses plastic film molding using a scattering box.

### [Disclosure]

### [Technical Problem]

It is an aspect of the present invention to provide an apparatus for manufacturing an EVA sheet for solar cell sealants, which can provide an EVA sheet having a uniform-thickness by spraying thermal adhesive resin powder to a uniform thickness.

### [Technical Solution]

The solution is achieved in accordance with claim 1.

The recess pattern of the powder arranging roll is uniformly distributed. In addition, the powder supply unit includes a plurality of ejection holes, and the powder arranging roll is disposed on each of the ejection holes.

The apparatus for manufacturing an EVA sheet for solar cell sealants includes: a powder supply unit having a barrel shape to receive thermal adhesive resin powder therein and formed with an ejection hole at a lower portion thereof; a powder arranging roll which disposed to seal the ejection hole and having a recess pattern receiving the thermal adhesive resin powder on a surface thereof; a circulation belt passing through a lower side of the powder arranging roll while circulating; a heater heating and fusion-bonding the thermal adhesive resin powder deposited onto the circulation belt; and a peel-off roll disposed at a rear end of the heater and separating a thermal adhesive resin powder sheet fusion-bonded in a film shape from the circulation belt.

Here, the apparatus may further include a winding roll winding the thermal adhesive resin film separated by the peel-off roll.

In addition, the powder arranging roll may rotate in an opposite direction to the circulation belt.

Further, the apparatus includes a brush or a gas injector, which removes unseparated thermal adhesive resin powder at an entrance side of the powder arranging roll.

The apparatus may further include a vibrator applying vibration to the powder arranging roll to facilitate removal of the thermal adhesive resin powder.

### [Advantageous Effects]

According to the present invention, the apparatus for manufacturing an EVA sheet for solar cell sealants can arrange thermal adhesive resin powder to uniform distribution and thickness, thereby improving quality of the EVA sheet.

### [Description of Drawings]

Fig. 1 is a schematic view of an apparatus for manufacturing an EVA sheet for solar cell sealants
Fig. 2 is a perspective view of a powder arranging roll.
Fig. 3 is a schematic view of an apparatus for manufacturing an EVA sheet for solar cell sealants according to an embodiment of the present invention.
Fig. 4 is a schematic view of an apparatus for manufacturing an EVA sheet for solar cell sealants according to a further embodiment of the present invention.

### [Best Mode]

The above and other aspects, features and advantages of the present invention will become apparent from the detailed description of the following embodiments in conjunction with the accompanying drawings. The invention is defined by the accompanying claims. Like components will be denoted by like reference numerals throughout the specification.

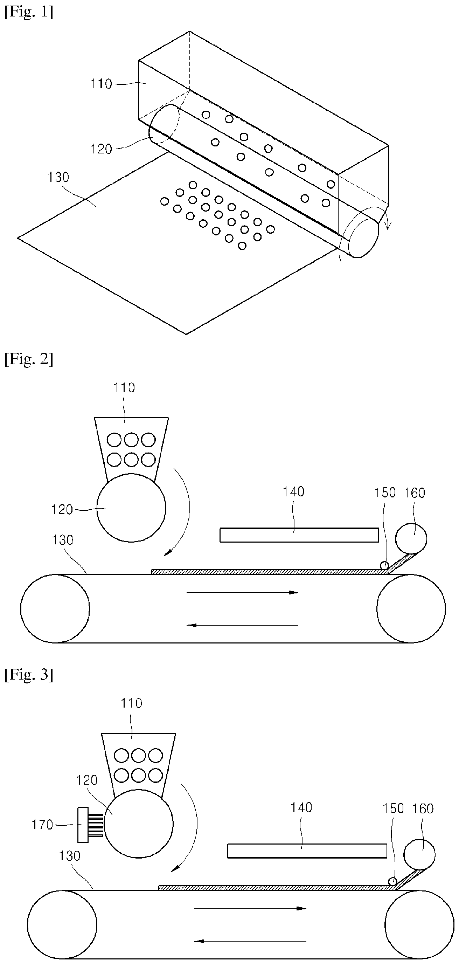

Fig. 1 is a schematic view of an apparatus for manufacturing an EVA sheet for solar cell sealants and Fig. 2 is a perspective view of a powder arranging roll.

An apparatus for manufacturing an EVA sheet for solar cell sealants is used to manufacture an EVA sheet by uniformly distributing (coating) thermal adhesive resin powder, followed by fusion-bonding of the thermal adhesive resin powder in a film form by heating the thermal adhesive resin powder.

Since the thermal adhesive resin powder (fine EVA powder) exhibits hygroscopicity due to an acetate group in an EVA backbone, it is not easy to deposit the powder to a constant thickness.

The present invention is aimed at preparing an EVA sheet by uniformly depositing the thermal adhesive resin powder using a powder arranging roll.

Here, the thermal adhesive resin powder refers to resin powder exhibiting adhesion by heating. Specifically, the ethylene resin includes polyethylene, ethylene-vinyl chloride copolymers, ethylene-vinyl acetate copolymers, ethylene-vinyl alcohol copolymers, and the like. The ethylene resin is a copolymer of ethylene and a resin copolymerizable with ethylene.

Examples of the ethylene resin include: copolymers of ethylene and vinyl esters such as vinyl acetate vinyl propionate and the like; copolymers of ethylene and unsaturated carboxylic acid esters such as methyl acrylate, ethyl acrylate, isobutyl acrylate, n-butyl acrylate, methyl methacrylate and the like; copolymers of ethylene and unsaturated carboxylic acids such as acrylic acid, methacrylic acid and the like; copolymers of ethylene, monomers obtained by partially neutralizing unsaturated carboxylic acids with a metal salt such as sodium, zinc, lithium salts and the like, and σ-olefins such as propylene, 1-butene, 1-hexene, 1-octene, 4-methyl-1-pentene and the like; mixtures thereof, and the like.

Preferably, the ethylene resin is an ethylene-vinyl acetate copolymer. Here, properties of the ethylene-vinyl acetate copolymer are determined by the degree of polymerization and the amount of ethylene in the copolymer. With increasing molecular weight of the ethylene-vinyl acetate copolymer, the ethylene-vinyl acetate copolymer exhibits improved properties in terms of toughness, plasticity, stress-cracking resistance and impact resistance, and exhibits deterioration in moldability and surface gloss. If the amount of ethylene in the copolymer is increased, the ethylene-vinyl acetate copolymer has improved properties in terms of density, elasticity, flexibility and compatibility with other polymers or plasticizers, and low softening temperature.

In addition, the ethylene resin may include polyethylene resins, without being limited thereto. The ethylene resin may include homopolymers of ethylene, copolymers in which a vinyl silane compound is grafted to polyethylene, and the like. More specifically, the ethylene resin is a copolymer in which ethylene is present in an amount of 60% by weight (wt%) or more and less than 90 wt%. More preferably, ethylene is present in an amount of 65 wt% to 75 wt%.

Here, the thermal adhesive layer may further include crosslinking agents, crosslinking aids, UV blocking agents and the like, as needed. Discoloration and deformation of the backsheet due to UV light and modularization can be minimized by addition of such additives.

The additives include crosslinking agents, UV blocking agents and the like, and may further include various other additives, as needed. Specifically, examples of the additives may include silane coupling agents, lubricants, antioxidants, flame retardants, anti-discoloration agents, and the like.

In the ethylene resin, if the amount of ethylene in the copolymer is less than 60 wt%, it is difficult to extract the copolymer into powder due to high adhesion of the copolymer. Although the powder is obtained, it becomes difficult to uniformly spray the powder due to deterioration in fluidity of the powder. If it is difficult to uniformly spray the powder, a uniform sheet for sealants cannot be obtained. Here, a non-uniform sheet for sealants means that a resin has a partially different porosity or a sheet has a non-uniform thickness depending upon locations. In addition, due to high adhesion of the copolymer, there is a problem in that the copolymer clings to process machines such as rolls, dies and the like in preparation of the sheet for sealants, thereby causing difficulty in film formation. Further, if the amount of ethylene in the copolymer is greater than 90 wt%, the sheet can suffer from deterioration in transparency and flexibility, and thus is not suitable as an EVA sheet for solar cell sealants.

In addition, the thermal adhesive resin powder may have a particle size from 30 mesh to 100 mesh. Here, the thermal adhesive resin powder may be obtained by mechanical pulverization, freeze pulverization, chemical pulverization, and the like. If the particle size of the powder is less than 30 mesh, the powder is very fine and can be blown off, or there is difficulty in adjusting the thickness or density of the EVA sheet. If the particle size of the powder is greater than 100 mesh, the powder exhibits poor fluidity and it is difficult to prepare a uniform-thickness EVA sheet.

As shown, an apparatus for manufacturing an EVA sheet for solar cell sealants includes: a powder supply unit 110 which has a barrel shape to receive thermal adhesive resin powder therein and has an ejection hole at a lower portion thereof; a powder arranging roll 120 which is disposed to seal the ejection hole and includes a recess pattern receiving the thermal adhesive resin powder on a surface thereof; a circulation belt 130 passing through a lower side of the powder arranging roll while circulating; a heater 140 heating the thermal adhesive resin powder deposited onto the circulation belt to perform fusion-bonding of the thermal adhesive resin powder; a peel-off roll 150 which is disposed at a rear end of the heater and removes a thermal adhesive resin powder sheet fusion-bonded in a film form from the circulation belt; and a winding roll 160 winding the thermal adhesive resin film separated by the peel-off roll 150.

The powder arranging roll 120 has the recess pattern on the surface thereof such that the recess pattern is filled with the thermal adhesive resin powder while the powder arranging roll 120 passes through the powder supply unit 110. Next, when the recess pattern faces downwards by rotation of the powder arranging roll 120, the thermal adhesive resin powder departs from the powder arranging roll and thus is deposited onto the circulation belt 130.

Here, the powder arranging roll 120 and the circulation belt 130 may rotate in opposite directions. When these belts rotate in the opposite directions, the thermal adhesive resin powder, which falls from the powder arranging roll 120, has a higher relative velocity with respect to the circulation belt 130, and thus is more uniformly distributed.

The thermal adhesive resin powder deposited onto the circulation belt 130 is heated by the heater 140 and fusion-bonded thereto.

Curing of the thermal adhesive resin powder by heating may be performed at a temperature from 70°C to 110°C.

If the curing temperature is less than 70°C, the thermal adhesive resin powder 300 cannot be sufficiently partially fusion-bonded. That is, since the EVA sheet exhibits flexibility exceeding suitable flexibility for sheets for solar cell sealants, there can be difficulty in fabrication of a solar cell module.

On the other hand, when the curing temperature is greater than 110°C, the resin powder is fusion-bonded in an amount close to the total amount thereof due to the overly high curing temperature. Thus, there can be problems in that the sheet cannot exhibit flexibility suitable for sheets for sealants, and that the sheet clings to the circulation belt 130 in the preparation thereof.

The thermal adhesive resin film formed by fusion-bonding of the thermal adhesive resin powder is separated from the circulation belt 130 while passing through the peel-off roll 150, and then is wound on the winding roll 160.

In the apparatus according to this embodiment, the powder supply unit 110 includes a single ejection hole and is connected to a single powder arranging roll 120. According to the invention, the powder supply unit includes a plurality of ejection holes and the powder arranging roll is disposed on each of the ejection holes.

In addition, the apparatus may include a plurality of powder supply units 110 connected to the single powder arranging roll 120 or the plurality of powder arranging rolls 120.

In this case, a process can be improved due to increase in amount of the supplied powder.

Fig. 3 is a schematic view of an apparatus for manufacturing an EVA sheet for solar cell sealants according to another embodiment of the present invention.

In this embodiment, the apparatus further includes a brush 170 at an entrance side of the powder arranging roll 120. Here, the term "entrance side of the powder arranging roll 120" refers to a portion of the powder arranging roll 120 when the powder arranging roll 120 approach the powder supply units 110 after the powder arranging roll 120 passes through an upper side of the circulation belt 130. The brush 170 serves to remove the thermal adhesive resin powder which does not fall from the powder arranging roll. The brush 170 serves to remove the thermal adhesive resin powder, which is not separated from the powder arranging roll by centrifugal force and gravity. If the thermal adhesive resin powder is not removed therefrom, continuous adsorption of the powder to the powder arranging roll can affect a volume of the thermal adhesive resin powder deposited by the recess pattern.

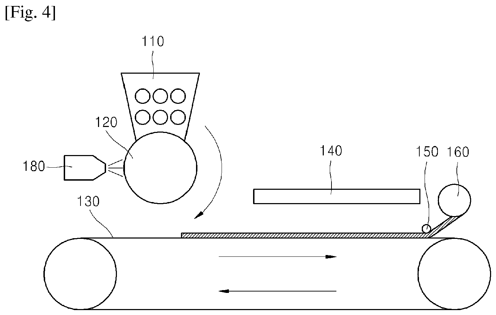

Fig. 4 is a schematic view of an apparatus for manufacturing an EVA sheet for solar cell sealants according to a further embodiment of the present invention.

In this embodiment, the apparatus further includes a compressed gas injector 180 instead of the brush 170 according to the embodiment of Fig. 3.

The compressed gas injector 180 injects compressed gas toward the powder arranging roll 120, thereby removing the thermal adhesive resin powder which is not separated from the powder arranging roll.

To facilitate separation of the thermal adhesive resin powder, which is received in the recess pattern on the powder arranging roll 120, toward the circulation belt 130, vibration may be applied to the powder arranging roll 120 using a vibrator. The vibrator may be disposed inside or outside the powder arranging roll 120.

In addition, to facilitate separation of the thermal adhesive resin powder, a surface of the powder arranging roll 120 may also be coated with Teflon or the like.

Hereinafter, thickness adjustment of the EVA sheet using the apparatus for manufacturing an EVA sheet for solar cell sealants according to the present invention will be described in detail.

For example, when the powder arranging roll includes 1420 recesses, each of which has a volume of 5 mm³, a total volume of the recesses formed in the powder arranging roll is 7,100 mm³.

Here, when the powder arranging roll is rotated at 100 rpm, a volume of 710,000 mm³ is coated per minute.

When the thermal adhesive resin powder supplied by the powder supply unit has an apparent specific gravity of 0.35, coating speed is 249 g/min.

Through adjustment of the rotational speed of the powder arranging roll and the moving speed of the circulation belt, the thickness of the thermal adhesive resin powder deposited onto the circulation belt can be adjusted.

## Claims

1. An apparatus for manufacturing an EVA sheet for solar cell sealants, comprising:
a powder supply unit (110) having a barrel shape to receive thermal adhesive resin powder therein and formed with an ejection hole at a lower portion thereof;
a powder arranging roll (120) disposed to seal the ejection hole and having a recess pattern receiving the thermal adhesive resin powder on a surface thereof, the recess pattern of the powder arranging roll being uniformly distributed;
a circulation belt (130) passing through a lower side of the powder arranging roll while circulating;
a heater (140) heating and fusion-bonding the thermal adhesive resin powder deposited onto the circulation belt;
a peel-off roll (150) disposed at a rear end of the heater and separating a thermal adhesive resin powder sheet fusion-bonded in a film shape from the circulation belt; and
a brush or a gas injector configured to remove unseparated thermal adhesive resin powder at the entrance side of the powder arranging roll (120);
wherein the powder supply unit (110) comprises a plurality of ejection holes and the powder arranging roll (120) is disposed on each of the ejection holes.

2. The apparatus according to claim 1, further comprising:
a winding roll (160) winding the thermal adhesive resin film separated by the peel-off roll (150).

3. The apparatus according to claim 1, wherein the powder arranging roll (120) rotates in an opposite direction to the circulation belt (130).

4. The apparatus according to claim 1, wherein the apparatus comprises a plurality of powder supply units and a plurality of powder arranging rolls.

5. The apparatus according to claim 1, further comprising: a vibrator applying vibration to the powder arranging roll.

## Patentansprüche

1. Vorrichtung zur Herstellung einer EVA-Folie für Solarzellendichtungsmittel, die Folgendes umfasst:
eine Pulverzuführeinheit (110) in Tonnenform zur Aufnahme von thermischem Klebeharzpulver und mit einem in ihrem unteren Teil ausgebildeten Auswurfloch;
eine Pulver verteilende Rolle (120), die so angeordnet ist, dass sie das Auswurfloch verschließt, und ein Muster aus Vertiefungen aufweist, das das thermische Klebeharzpulver auf seiner Oberfläche aufnimmt, wobei die Vertiefungen der Pulver verteilenden Rolle gleichmäßig verteilt sind;
ein umlaufendes Förderband (130), das beim Umlauf die Unterseite der Pulver verteilenden Rolle passiert;
eine Heizvorrichtung (140), die das auf dem umlaufenden Förderband abgesetzte thermische Klebeharzpulver erwärmt und durch Fusion-Bonding verbindet;
eine Abziehrolle (150), die am hinteren Ende der Heizvorrichtung angeordnet ist und das durch Fusion-Bonding zur Folie verbundene, thermische Klebeharzpulver von dem umlaufenden Förderband trennt; und
eine Bürste oder eine Gaseinspritzvorrichtung, die so konfiguriert ist, dass sie auf der Eingangsseite der Pulver verteilenden Rolle (120) das nicht getrennte thermische Klebeharzpulver entfernt;
wobei die Pulverzuführeinheit (110) eine Vielzahl von Auswurflöchern umfasst und die Pulver verteilende Rolle (120) an jedem der Auswurflöcher angeordnet ist.

2. Vorrichtung nach Anspruch 1, die ferner Folgendes umfasst:
eine Wickelrolle (160), die die durch die Abziehrolle (150) getrennte thermische Klebeharzfolie aufwickelt.

3. Vorrichtung nach Anspruch 1, wobei sich die Pulver verteilende Rolle (120) in entgegengesetzter Richtung zum umlaufenden Förderband (130) dreht.

4. Vorrichtung nach Anspruch 1, wobei die Vorrichtung eine Vielzahl von Pulverzuführeinheiten und eine Vielzahl von Pulver verteilenden Rollen umfasst.

5. Vorrichtung nach Anspruch 1, die ferner eine Rüttelvorrichtung umfasst, die die Pulver verteilende Rolle in Schwingung versetzt.

## Revendications

1. Appareil de fabrication d'une feuille d'éthylène acétate de vinyle pour matériau d'encapsulation de cellule solaire, comprenant :
une unité d'alimentation en poudre (110) ayant une forme de tonneau afin de recevoir en son sein de la poudre de résine thermique adhésive et formée avec un trou d'éjection au niveau d'une partie inférieure de celle-ci ;
un rouleau d'arrangement de poudre (120) disposé afin de sceller le trou d'éjection et ayant un motif évidé recevant la poudre de résine thermique adhésive sur une surface de celui-ci, le motif évidé du rouleau d'arrangement de poudre étant réparti de façon uniforme ;
une courroie de circulation (130) passant à travers un côté inférieur du rouleau d'arrangement de poudre pendant sa circulation ;
un élément chauffant (140) chauffant et liant par fusion la poudre de résine thermique adhésive déposée sur la courroie de circulation ;
un rouleau de décollage (150) disposé au niveau d'une extrémité arrière de l'élément chauffant et séparant une feuille de poudre de résine thermique adhésive liée par fusion en une forme de film de la courroie de circulation ; et
une brosse ou un injecteur de gaz conçu(e) pour retirer la poudre de résine thermique adhésive non séparée au niveau d'un côté d'entrée du rouleau d'arrangement de poudre (120) ;
dans lequel l'unité d'alimentation en poudre (110) comprend une pluralité de trous d'éjection et le rouleau d'arrangement de poudre (120) est disposé sur chacun des trous d'éjection.

2. Appareil selon la revendication 1, comprenant en outre :
un rouleau d'enroulement (160) enroulant le film de résine thermique adhésive séparé par le rouleau de décollage (150).

3. Appareil selon la revendication 1, dans lequel le rouleau d'arrangement de poudre (120) tourne dans une direction opposée par rapport à la courroie de circulation (130).

4. Appareil selon la revendication 1, dans lequel l'appareil comprend une pluralité d'unités d'alimentation en poudre et une pluralité de rouleaux d'arrangement de poudre.

5. Appareil selon la revendication 1, comprenant en outre : un vibrateur appliquant une vibration sur le rouleau d'arrangement de poudre.
